# EUROPEAN PATENT APPLICATION

(11) **EP 4 783 771 A1**
(43) Date of publication of application: **29.07.2026**
(21) Application number: 25193731.4
(22) Date of filing: 04.08.2025
(51) Int. Cl.: H10D 84/01, H10D 84/03, H10D 84/83, H10D 84/85, H10D 30/00

(54) **SEMICONDUCTOR DEVICE AND METHOD OF FABRICATING THE SAME**

(30) Priority: 22.01.2025 KR 20250009434
(71) Applicant: Samsung Electronics Co., Ltd., Suwon-si, Gyeonggi-do 16677 (KR)
(72) Inventor: KIM, Hyojin, 16677 Suwon-si, Gyeonggi-do (KR); PARK, Jihoon, 16677 Suwon-si, Gyeonggi-do (KR); SONG, Young-Soo, 16677 Suwon-si, Gyeonggi-do (KR)
(74) Representative: Kuhnen & Wacker Patent- und Rechtsanwaltsbüro PartG mbB

(57) **Abstract**

A semiconductor device may include a first active region on a substrate, a first channel pattern and a second channel pattern on the first active region, each of the first and second channel patterns including a plurality of semiconductor patterns, which are vertically stacked to be spaced apart from each other, a first gate pattern crossing the first channel pattern, a second gate pattern crossing the second channel pattern, and an insertion pattern between the lowermost one of the semiconductor patterns of the second channel pattern and the substrate. The number of inner electrodes of the first gate pattern may be greater than the number of inner electrodes of the second gate pattern, and the second gate pattern may cover a side surface of the insertion pattern.

## Description

### CROSS-REFERENCE TO RELATED APPLICATIONS

This U.S. non-provisional patent application claims priority under 35 U.S.C. §119 to Korean Patent Application No. 10-2025-0009434, filed on January 22, 2025, in the Korean Intellectual Property Office, the entire contents of which are hereby incorporated by reference.

### BACKGROUND

A semiconductor device includes an integrated circuit, which in turn includes metal-oxide-semiconductor field-effect transistors (MOS-FETs). To meet an increasing demand for a semiconductor device with a small pattern size and for reduced design overhead, the MOS-FETs are being aggressively scaled down. The scale-down of the MOS-FETs may lead to deterioration in operational properties of the semiconductor device. A variety of studies are being conducted to overcome technical limitations associated with the scale-down of the semiconductor device and to realize high-performance semiconductor devices.

### SUMMARY

The present disclosure relates to a semiconductor device and a method of fabricating the same, and in particular, to a semiconductor device including a field effect transistor and a method of fabricating the same.

An implementation of the techniques discussed herein provides a semiconductor device with an increased degree of freedom and a method of fabricating the same.

An implementation of the techniques discussed herein provides a semiconductor device with improved electric and productivity characteristics and a method of fabricating the same.

According to an implementation of the techniques discussed herein, a semiconductor device may include a first active region on a substrate, a first channel pattern and a second channel pattern on the first active region, each of the first channel pattern and the second channel pattern including a plurality of semiconductor patterns where the plurality of semiconductor patterns are vertically stacked with respect to the substrate and are spaced apart from each other, a first gate pattern crossing the first channel pattern, a second gate pattern crossing the second channel pattern, and an insertion pattern between the substrate and a lowermost semiconductor pattern of the plurality of semiconductor patterns of the second channel pattern. A number of inner electrodes of the first gate pattern may be greater than a number of inner electrodes of the second gate pattern, and where the second gate pattern may cover a side surface of the insertion pattern.

According to an implementation of the techniques discussed herein, a semiconductor device may include a first active region on a substrate, a first channel pattern and a second channel pattern on the first active region, each of the first channel pattern and the second channel pattern including a plurality of semiconductor patterns, where the plurality of semiconductor patterns are vertically stacked with respect to the substrate and are spaced apart from each other, a first gate pattern crossing the first channel pattern, a second gate pattern crossing the second channel pattern, and an insertion pattern between the substrate and a lowermost semiconductor pattern of the plurality of semiconductor patterns of the second channel pattern. A number of inner electrodes of the first gate pattern may be greater than a number of inner electrodes of the second gate pattern, and a bottom surface of the second gate pattern may be located at a vertical level that is lower, with respect to the substrate, than a vertical level of a top surface of the insertion pattern.

According to an implementation of the techniques discussed herein, a semiconductor device may include a first active region including a first region and a second region, on a substrate, a first channel pattern on the first region and a second channel pattern on the second region, each of the first channel pattern and the second channel pattern including a plurality of semiconductor patterns that are vertically stacked with respect to the substrate and are spaced apart from each other, a source/drain pattern on the first active region, an active contact on a top surface of the source/drain pattern, a first gate pattern crossing the first channel pattern, the first gate pattern including inner electrodes interposed between the plurality of semiconductor patterns of the first channel pattern and between the first channel pattern and the substrate, a second gate pattern crossing the second channel pattern, the second gate pattern including inner electrodes positioned between the plurality of semiconductor patterns of the second channel pattern, a gate contact on a top surface of the second gate pattern, and an insertion pattern between the substrate and a lowermost semiconductor pattern of the plurality of semiconductor patterns of the second channel pattern and the substrate. A number of the inner electrodes of the first gate pattern may be greater than a number of the inner electrodes of the second gate pattern, and the second gate pattern may cover a side surface of the insertion pattern.

According to an implementation of the techniques discussed herein, a method of fabricating a semiconductor device may include forming a stacking pattern on a first active region including a first region and a second region, the stacking pattern including a first sacrificial layer on the substrate and semiconductor layers and second sacrificial layers alternatingly stacked on the first sacrificial layer; forming a recess mask patterns on a top surface of the stacking pattern; forming a first interlayer insulating layer between the recess mask patterns; removing the recess mask patterns on the second region to expose the first sacrificial layer and the second sacrificial layers on the second region; and removing the exposed first sacrificial layer, and forming an insertion pattern in a region where the exposed first sacrificial layer is removed. A first material in the first sacrificial layer may be the same as a second material in each of the second sacrificial layers, and an atomic concentration of the first material may be higher than an atomic concentration of the second material.

In an implementation, each of the first and second sacrificial layers may include SiGe, and each of the first and second materials may be Ge.

In an implementation, the atomic concentration of the first material may range from 35 at% to 55 at%.

In an implementation, the atomic concentration of the second material may be equal to or higher than 15 at% and may be lower than 35 at%.

In an implementation, after the formation of the insertion pattern, the method may further include removing the recess mask patterns on the first region to expose first sacrificial layer and second sacrificial layers on the first region.

In an implementation, after the formation of the insertion pattern, the method may further include removing the exposed first sacrificial layer on the first region and the exposed second sacrificial layers on the first and second regions.

In an implementation, the method may further include forming a first gate pattern in each of regions where the exposed first sacrificial layer on the first region and the exposed second sacrificial layers on the first region are removed, and forming a second gate pattern in a region where the exposed second sacrificial layers on the second region are removed.

In an implementation, the insertion pattern may be a composite material of Si and N, such as SiN and SiOCN.

In an implementation, the method may further include removing a portion of the stacking pattern using the recess mask patterns as an etch mask; and forming a source/drain pattern in a region where the portion of the stacking pattern is removed, after the formation of the recess mask patterns and before the formation of the first interlayer insulating layer.

In an implementation, the source/drain pattern may include a first pattern on the first region and a second pattern on the second region, and a bottom surface of the second pattern may be placed at a vertical level higher than a bottom surface of the first sacrificial layer.

### BRIEF DESCRIPTION OF THE DRAWINGS

FIG. 1 is a plan view illustrating a semiconductor device according to an implementation of the techniques discussed herein.
FIG. 2A is a sectional view corresponding to a line A-A' of FIG. 1.
FIG. 2B is a sectional view corresponding to lines B-B' and C-C' of FIG. 1.
FIG. 3A is a sectional view corresponding to the line A-A' of FIG. 1.
FIG. 3B is a sectional view corresponding to the lines B-B' and C-C' of FIG. 1.
FIG. 4A is a sectional view corresponding to the line A-A' of FIG. 1.
FIG. 4B is a sectional view corresponding to the lines B-B' and C-C' of FIG. 1.
FIG. 5 is an enlarged sectional view corresponding to a portion P1 of FIG. 4B.
FIG. 6A is a sectional view corresponding to the line A-A' of FIG. 1.
FIG. 6B is a sectional view corresponding to the lines B-B' and C-C' of FIG. 1.
FIG. 7 is an enlarged sectional view corresponding to a portion P2 of FIG. 6B.
FIG. 8A, FIG. 8B, FIG. 9A, FIG. 9B, FIG. 10A, FIG. 10B, FIG. 11A, FIG. 11B, FIG. 12A, and FIG. 12B are diagrams illustrating a method of fabricating a semiconductor device according to an implementation of the techniques discussed herein.
FIGS. 13A and 13B are diagrams illustrating a method of fabricating a semiconductor device according to an implementation of the techniques discussed herein.
FIG. 14A, FIG. 14B, FIG. 15A, and FIG. 15B are diagrams illustrating a method of fabricating a semiconductor device according to an implementation of the techniques discussed herein.

### DETAILED DESCRIPTION

Example implementations of the techniques discussed herein will now be described more fully with reference to the accompanying drawings, in which example implementations are shown.

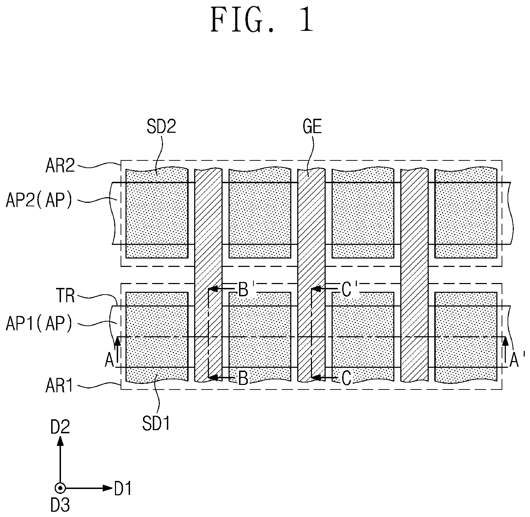

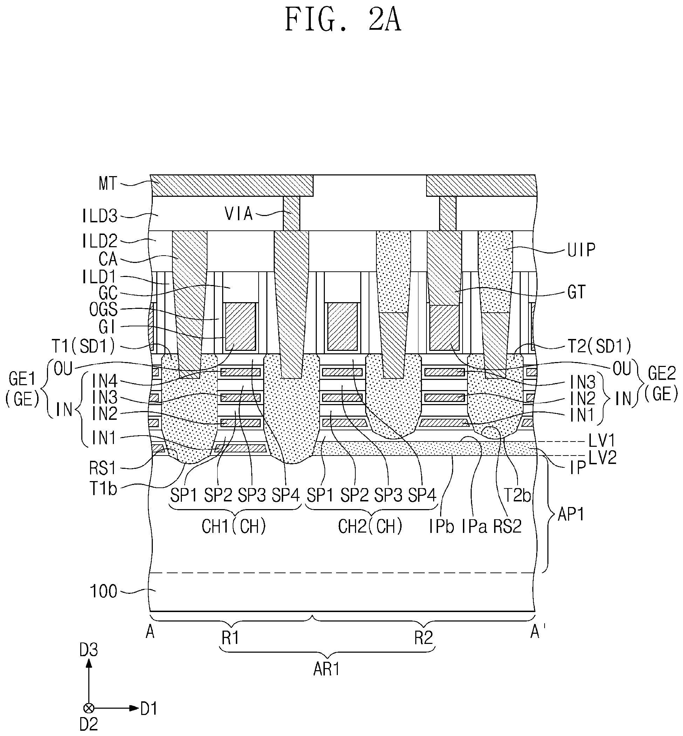

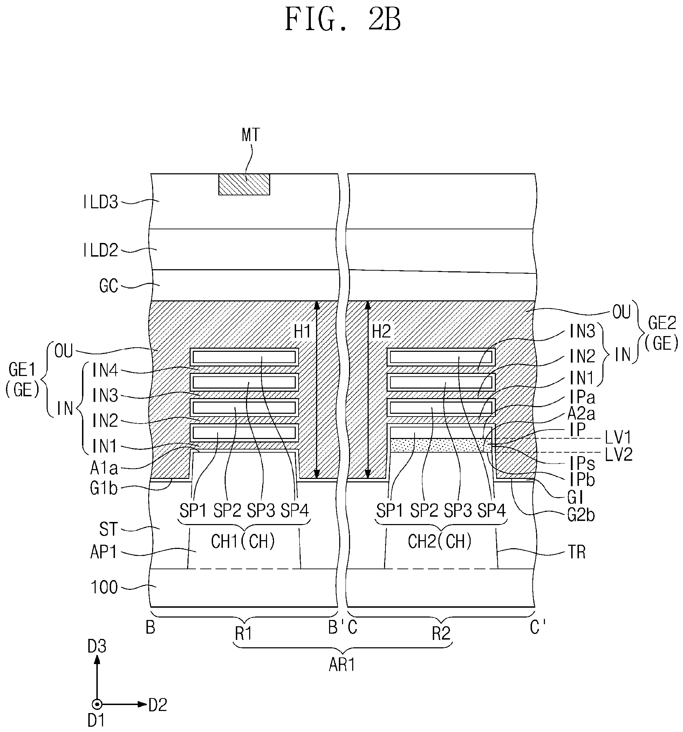

FIG. 1 is a plan view illustrating a semiconductor device according to an implementation of the techniques discussed herein. FIG. 2A is a sectional view corresponding to a line A-A' of FIG. 1. FIG. 2B is a sectional view corresponding to lines B-B' and C-C' of FIG. 1.

Referring to FIGS. 1, 2A, and 2B, a substrate 100 including a single height cell may be provided. In an implementation, the substrate 100 may be a semiconductor substrate including at least one of silicon, germanium and silicon-germanium or may be a compound semiconductor substrate. In the present specification, each of the expressions of "A or B", "at least one of A and B", "at least one of A or B", "A, B, or C", "at least one of A, B, and C", and "at least one of A, B, or C" may be used to represent one of the elements enumerated in the expression or any possible combination of the enumerated elements. As another example, the substrate 100 may be an insulating substrate including an insulating material. As an example, the substrate 100 may be a plate-shaped structure extended in a first direction D1 and a second direction D2. The first and second directions D1 and D2 may be parallel to a top surface of the substrate 100 and may not be parallel to each other.

The single height cell may constitute a single logic cell. In the present specification, the logic cell may mean a logic device (e.g., AND, OR, XOR, XNOR, inverter, and so forth), which is configured to execute a specific function. In other words, the logic cell may include transistors constituting the logic device and interconnection lines connecting the transistors to each other.

The single height cell is illustrated as a single element in the drawings, but the techniques discussed herein is not limited to this example. In an implementation, a plurality of single height cells may be provided. The single height cells may be spaced apart from each other in the first and second directions D1 and D2.

The single height cell may include a first active region AR1 and a second active region AR2. Each of the first and second active regions AR1 and AR2 may be extended in the first direction D1, on the substrate 100. The first and second active regions AR1 and AR2 may be adjacent to each other in the second direction D2. In an implementation, the first active region AR1 may be an NMOSFET region, and the second active region AR2 may be a PMOSFET region.

An active pattern AP may be provided on the substrate 100. The active pattern AP may be defined by a trench TR, which is formed in an upper portion of the substrate 100. In the case where the substrate 100 includes a semiconductor substrate, the active pattern AP may be a portion of the substrate 100. A portion of the substrate 100 may protrude in a third direction D3. The third direction D3 may be perpendicular to the top surface of the substrate 100.

The active pattern AP may include a first active pattern AP1, which is provided on the first active region AR1 and is extended in the first direction D1, and a second active pattern AP2, which is provided on the second active region AR2 and is extended in the second direction D2.

A device isolation pattern ST may be provided on the substrate 100 to fill the trench TR. In an implementation, the device isolation pattern ST may be formed of or include an insulating material.

A channel pattern CH may be provided on the active pattern AP. In an implementation, a plurality of channel patterns CH may be provided. The channel pattern CH may include a first semiconductor pattern SP1, a second semiconductor pattern SP2, a third semiconductor pattern SP3, and a fourth semiconductor pattern SP4, which are spaced apart from each other in the third direction D3, but the techniques discussed herein is not limited to this example. The channel pattern CH may include three or more semiconductor patterns. Each of the first to fourth semiconductor patterns SP1, SP2, SP3, and SP4 may be formed of or include crystalline silicon.

The channel pattern CH may include a first channel pattern CH1 and a second channel pattern CH2 on the active pattern AP. In an implementation, a plurality of first channel patterns CH1 may be provided. The first channel patterns CH1 may be provided on the first active pattern AP1. The first channel patterns CH1 may be provided on the second active pattern AP2. The first channel patterns CH1 may be spaced apart from each other in the first direction D1, on the first active region AR1. The first channel patterns CH1 may be spaced apart from each other in the first direction D1, on the second active region AR2.

In an implementation, a plurality of second channel patterns CH2 may be provided. The second channel patterns CH2 may be provided on the first active pattern AP1. The second channel patterns CH2 may be provided on the second active pattern AP2. The second channel patterns CH2 may be spaced apart from each other in the first direction D1, on the first active region AR1. The second channel patterns CH2 may be spaced apart from each other the first direction D1, on the second active region AR2. The second channel pattern CH2 may be spaced apart from the first channel pattern CH1 in the first direction D1.

A first recess RS1 may be defined between the first channel patterns CH1. A second recess RS2 may be defined between the second channel patterns CH2. A recess, which has the same or similar shape as the first recess RS1, may be defined between the first channel patterns CH1 of the second active region AR2. A recess, which has the same or similar shape as the second recess RS2, may be defined between the second channel patterns CH2 of the second active region AR2.

A first source/drain pattern SD1 may be provided on the first active pattern AP1. The first source/drain pattern SD1 may fill the first and second recesses RS1 and RS2 on the first active region AR1. The first source/drain pattern SD1 may be connected to the first to fourth semiconductor patterns SP1, SP2, SP3, and SP4 on the first active region AR1.

A second source/drain pattern SD2 may be provided on the second active pattern AP2. The second source/drain pattern SD2 may fill recesses formed on the second active region AR2. The second source/drain pattern SD2 may be connected to the first to fourth semiconductor patterns SP1, SP2, SP3, and SP4 on the second active region AR2.

The first source/drain pattern SD1 may include a first pattern T1 provided between the first channel patterns CH1 and a second pattern T2 provided between the second channel patterns CH2. A height of the first pattern T1 of the first source/drain pattern SD1 may be larger than a height of the second pattern T2 of the first source/drain pattern SD1. In an implementation, a bottom surface T1b of the first pattern T1 of the first source/drain pattern SD1 may be located at a vertical level lower than a bottom surface T2b of the second pattern T2 of the first source/drain pattern SD1.

Similar to the first source/drain pattern SD1, the second source/drain pattern SD2 may include a first pattern provided between the first channel patterns CH1 and a second pattern provided between the second channel patterns CH2. The first and second patterns T1 and T2 of the second source/drain pattern SD2 may be provided to have substantially the same features as the first and second patterns T1 and T2 of the first source/drain pattern SD1 described above.

The first source/drain pattern SD1 may be impurity regions of a first conductivity type (e.g., n-type). In an implementation, the first source/drain pattern SD1 may be formed of or include the same semiconductor element (e.g., Si) as the substrate 100.

The second source/drain pattern SD2 may be impurity regions of a second conductivity type (e.g., p-type). The second source/drain pattern SD2 may be formed of or include a semiconductor material (e.g., SiGe) whose lattice constant is larger than that of a semiconductor material of the channel pattern CH.

A gate pattern GE may be provided on the channel pattern CH and may cross the channel pattern CH. In an implementation, a plurality of gate patterns GE may be provided. Each of the gate patterns GE may be extended in the second direction D2 and may be alternately arranged in the first direction D1.

The gate pattern GE may include inner electrodes IN and an outer electrode OU. The inner electrodes IN of the gate pattern GE may be provided between the uppermost semiconductor pattern SP4 of the semiconductor patterns SP1, SP2, SP3, and SP4 and the substrate 100 (or the active pattern AP). The outer electrode OU of the gate pattern GE may be provided on the uppermost semiconductor pattern SP4.

The gate pattern GE may include a first metal pattern and a second metal pattern on the first metal pattern. The first metal pattern may include a work-function metal, which can be used to adjust a threshold voltage of a transistor. In an implementation, the first metal pattern may be formed of or include at least one of metallic materials (e.g., Ti, Mo, W, Cu, Al, Ta, Ru, Ir, and Co) and metal nitride materials (e.g., nitrides of Ti, Mo, W, Cu, Al, Ta, Ru, Ir, and Co). In an implementation, the first metal pattern may further include carbon (C). The first metal pattern may be formed of or include at least one of metallic materials having different work functions.

In an implementation, the second metal pattern may be formed of or include at least one of metallic materials (e.g., Ti, Mo, W, Cu, Al, Ta, Ru, Ir, and Co) whose electric resistances are lower than that of the first metal pattern.

Each of the inner electrodes IN of the gate pattern GE may include a first metal pattern. The outer electrode OU of the gate pattern GE may include a first metal pattern and a second metal pattern.

The gate pattern GE may include a first gate pattern GE1 crossing the first channel pattern CH1 and a second gate pattern GE2 crossing the second channel pattern CH2. The number of the inner electrodes IN of the first gate pattern GE1 may be greater than the number of the inner electrodes IN of the second gate pattern GE2. In an implementation, the inner electrodes IN of the first gate pattern GE1 may include first to fourth inner electrodes IN1, IN2, IN3, and IN4, which are spaced apart from each other in the third direction D3. In an implementation, the inner electrodes IN of the second gate pattern GE2 may include the first to third inner electrodes IN1, IN2, and IN3, which are spaced apart from each other in the third direction D3. A height H1 of the first gate pattern GE1 may be substantially equal to a height H2 of the second gate pattern GE2. As used throughout this disclosure, A being substantially equal to or substantially same as B can refer to the value of A being within 1%, 5% or 10% of the value of B or the value of B being within 1%, 5% or 10% of the value of A. In an implementation, a bottom surface G1b of the first gate pattern GE1 may be located at substantially the same vertical level as a bottom surface G2b of the second gate pattern GE2.

A portion of the first active region AR1, on which the first gate pattern GE1 is provided, may be defined as a first region R1, and another portion of the first active region AR1, on which the second gate pattern GE2 is provided, may be defined as a second region R2. The channel pattern CH provided on the first region R1 may be the first channel pattern CH1, and the channel pattern CH provided on the second region R2 may be the second channel pattern CH2. A top surface A1a of the first active pattern AP1 below the first channel pattern CH1 may be located at substantially the same vertical level as a top surface A2a of the first active pattern AP1 below the second channel pattern CH2.

A portion of the second active region AR2, on which the first gate pattern GE1 is provided, may be defined as a first region, and another portion of the second active region AR2, on which the second gate pattern GE2 is provided, may be defined as a second region.

As an example, the structure on the first region R1 may be provided to have four layers, and the structure on the second region R2 may be provided to have three layers. In the present specification, the number of layers may be determined depending on the number of the inner electrodes IN of the gate pattern GE. For example, if the number of layers on the first region R1 is n, the number of layers on the second region R2 may be n - x, where n is an integer greater than one, and x is an integer such that n - x is greater than zero.

A gate capping pattern GC may be provided on a top surface of the gate pattern GE. In an implementation, the gate capping pattern GC may be formed of or include at least one of SiON, SiCN, SiOCN, or SiN.

Gate spacers OGS may be provided on side surfaces of the outer electrode OU of the gate pattern GE and may be respectively extended to regions on side surfaces of the gate capping pattern GC. The gate spacer GS may include a single layer or a composite layer. In an implementation, the gate spacer GS may be formed of or include at least one of SiON, SiCN, SiOCN, or SiN.

A gate insulating pattern GI may be interposed between the gate pattern GE and the first to fourth semiconductor patterns SP1, SP2, SP3, and SP4. The gate insulating pattern GI may cover a top surface, a bottom surface, and opposite side surfaces of each of the first to fourth semiconductor patterns SP1, SP2, SP3, and SP4. The gate insulating pattern GI may be interposed between the outer electrode OU and the gate spacer OGS. As an example, the gate insulating pattern GI may be formed of or include at least one of silicon oxide (SiO₂), silicon oxynitride (SiON), or high-k dielectric materials. In the present specification, the high-k dielectric material may be defined as a material having a dielectric constant higher than that of silicon oxide.

An inner spacer may be interposed between the second source/drain pattern SD2 and the gate insulating pattern GI.

A first interlayer insulating layer ILD1 may be provided on the substrate 100. The first interlayer insulating layer ILD1 may cover the gate spacers OGS and first and second source/drain patterns SD1 and SD2. In an implementation, a top surface of the first interlayer insulating layer ILD1 may be located at substantially the same a level as a top surface of the gate capping pattern GC.

A second interlayer insulating layer ILD2 may be provided on the first interlayer insulating layer ILD1 to cover the gate capping pattern GC. A third interlayer insulating layer ILD3 may be provided on the second interlayer insulating layer ILD2. In an implementation, the first to third interlayer insulating layers ILD1, ILD2, and ILD3 may be formed silicon oxide (SiO₂).

Each of active contacts CA may be provided to penetrate the first and second interlayer insulating layers ILD1 and ILD2. Lower portions of the active contacts CA may be inserted into upper portions of the first and second source/drain patterns SD1 and SD2, respectively. In an implementation, the active contact CA may be formed of or include at least one of metallic materials (e.g., Ti, Mo, W, Cu, Al, Ta, Ru, Ir, and Co), metal nitride materials (e.g., containing Ti, Mo, W, Cu, Al, Ta, Ru, Ir, or Co), and metal silicide materials (e.g., containing Ti, Mo, W, Cu, Al, Ta, Ru, or Ir). In an implementation, a bottom surface of each of the active contacts CA may be located at a vertical level lower than a top surface of the uppermost semiconductor pattern SP4 of the semiconductor patterns SP1, SP2, SP3, and SP4 of the channel pattern CH.

A gate contact GT may be provided to penetrate the second interlayer insulating layer ILD2 and the gate capping pattern GC in the third direction D3. The gate contact GT may be inserted in an upper portion of the outer electrode OU of the gate pattern GE. In an implementation, the gate contact GT may be formed of or include at least one of metallic materials (e.g., Ti, Mo, W, Cu, Al, Ta, Ru, Ir, or Co) or metal nitride materials (e.g., containing Ti, Mo, W, Cu, Al, Ta, Ru, Ir, or Co).

An upper insulating layer UIP containing an insulating material may be provided on one of the active contacts CA. The active contact CA described above may be adjacent to the gate contact GT.

Metal patterns MT may be provided in the third interlayer insulating layer ILD3. Via patterns VIA may be interposed between the metal patterns MT and the active contacts CA and between the metal patterns MT and the gate contacts. The metal patterns MT and the via patterns VIA may be provided in plurality, and the metal patterns MT and each of the via patterns VIA may be alternately stacked. The metal patterns MT and the via patterns VIA may be formed of or include at least one of metallic materials (e.g., Ti, Mo, W, Cu, Al, Ta, Ru, Ir, and Co).

The drawings illustrate an example, in which a power is supplied to the first and second source/drain patterns SD1 and SD2 through conductive lines and plug patterns (e.g., the metal patterns MT and the via patterns VIA) provided in the first to third interlayer insulating layers ILD1, ILD2, and ILD3, but the techniques discussed herein is not limited to this example. As another example, additional conductive lines and plug patterns may be buried in the substrate 100 or may be provided on a bottom surface of the substrate 100. Thus, a power (e.g., a source voltage or a drain voltage) may be supplied to the first and second source/drain patterns SD1 and SD2 through a rear surface of the substrate 100.

An insertion pattern IP may be provided on the second region R2. The insertion pattern IP may be interposed between the second pattern T2 of the first source/drain pattern SD1 and the first active pattern AP1. The insertion pattern IP may be extended in the first direction D1, below the second pattern T2 of the first source/drain pattern SD1. The insertion pattern IP may be extended from a side surface of the first pattern T1 of the first source/drain pattern SD1 in the first direction D1.

The insertion pattern IP may be interposed between the lowermost semiconductor pattern SP1 of the semiconductor patterns SP1, SP2, SP3, and SP4 of the second channel pattern CH2 and the substrate 100 (or the first active pattern AP1). Thus, unlike the first inner electrode IN1 of the first gate pattern GE1, the inner electrode IN of the second gate pattern GE2 may not be provided between the lowermost semiconductor pattern SP1 of the semiconductor patterns SP1, SP2, SP3, and SP4 of the second channel pattern CH2 and the substrate 100 (or the first active pattern AP1). The insertion pattern IP may be adjacent to the first inner electrode IN1 of the first gate pattern GE1 in the first direction D1 (i.e., a horizontal direction). The first inner electrode IN1 of the second gate pattern GE2 may be adjacent to the second inner electrode IN2 of the first gate pattern GE1in the first direction D1. The second inner electrode IN2 of the second gate pattern GE2 may be adjacent to the third inner electrode IN3 of the first gate pattern GE1 in the first direction D1. The third inner electrode IN3 of the second gate pattern GE2 may be adjacent to the fourth inner electrode IN4 of the first gate pattern GE1 in the first direction D1.

The bottom surface G2b of the second gate pattern GE2 may be located at a vertical level lower than a first level LV1. The first level LV1 may be defined as a vertical level, at which a top surface IPa of the insertion pattern IP is located. Thus, the second gate pattern GE2 may cover a side surface IPs of the insertion pattern IP. The gate insulating pattern GI may be interposed between the second gate pattern GE2 and the insertion pattern IP. The gate insulating pattern GI may cover the side surface IPs of the insertion pattern IP.

In an implementation, the bottom surface G2b of the second gate pattern GE2 may not be located at a vertical level that is substantially equal to or lower than a second level LV2. The second level LV2 may be defined as a vertical level, at which the bottom surface IPb of the insertion pattern IP is located.

The bottom surface T1b of the first pattern T1 of the first source/drain pattern SD1 may be located at a vertical level that is substantially equal to or lower than the second level LV2. The bottom surface T2b of the second pattern T2 of the first source/drain pattern SD1 may be located at a vertical level that is substantially equal to or higher than the first level LV1, but the techniques discussed herein is not limited to this example. As another example, the bottom surface T2b of the second pattern T2 of the first source/drain pattern SD1 may be located between the first level LV1 and the second level LV2.

The insertion pattern IP may include an insulating material. In an implementation, the insertion pattern IP may be formed of or include a nitride material. The insertion pattern IP may be formed of or include a composite material of Si and N, such as SiN and SiOCN.

According to an implementation of the techniques discussed herein, the insertion pattern IP, which includes an insulating material, may be interposed between the lowermost semiconductor pattern SP1 of the semiconductor patterns SP1, SP2, SP3, and SP4 of the second channel pattern CH2 and the first active pattern AP1. Thus, unlike the first region R1, the inner electrode IN of the second gate pattern GE2 in the second region R2 may not be provided between the lowermost semiconductor pattern SP1 and the first active pattern AP1. As a result, an overlapping region between the second gate pattern GE2 and the second channel pattern CH2 may be smaller than an overlapping region between the first gate pattern GE1 and the first channel pattern CH1. When the overlapping region therebetween increases, the electrical characteristics of the semiconductor device may improve, but power consumption may also increase. In sum, since the first and second regions R1 and R2 with different numbers of layers are provided on each active region, it may be possible to simultaneously provide a device with improved electrical characteristics and a device with improved power consumption characteristics, on each active region. Thus, it may be possible to improve a degree of freedom in designing a semiconductor device.

According to an implementation of the techniques discussed herein, since the insertion pattern IP is provided on the second region R2, it may be possible to reduce a parasitic capacitance between the first source/drain pattern SD1 and the second gate pattern GE2. In addition, the insertion pattern IP may include a nitride-containing insulating material, and thus, it may be possible to more effectively reduce the parasitic capacitance. As a result, the electric characteristics of the semiconductor device may be improved.

The relationships between the insertion pattern IP and neighboring elements on the first active region AR1 described above may be similarly or identically applied to the relationship between the insertion pattern IP and neighboring elements on the second active region AR2.

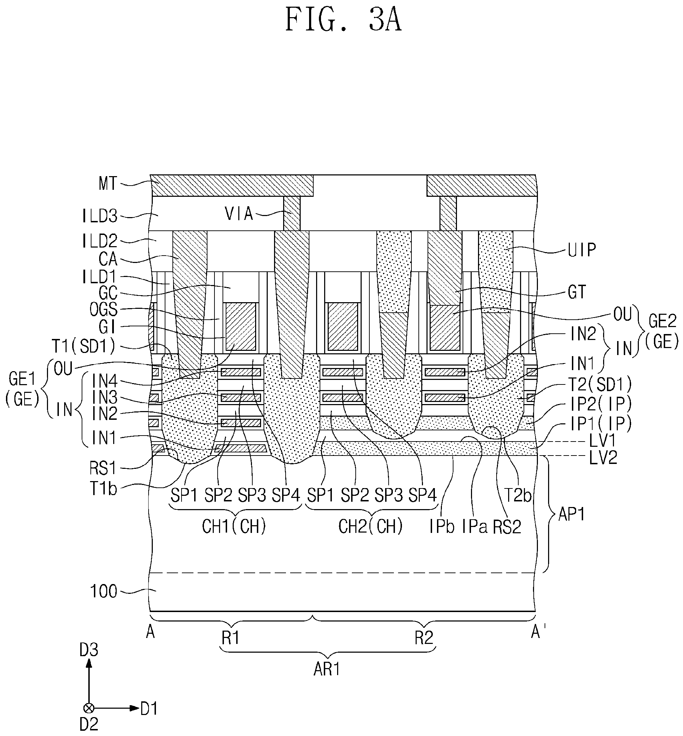

Hereinafter, a semiconductor device according to an implementation of the techniques discussed herein will be described with reference to FIGS. 3A to 6B. In the following description, a previously-described element may be identified by the same reference number without repeating an overlapping description thereof, for concise description.

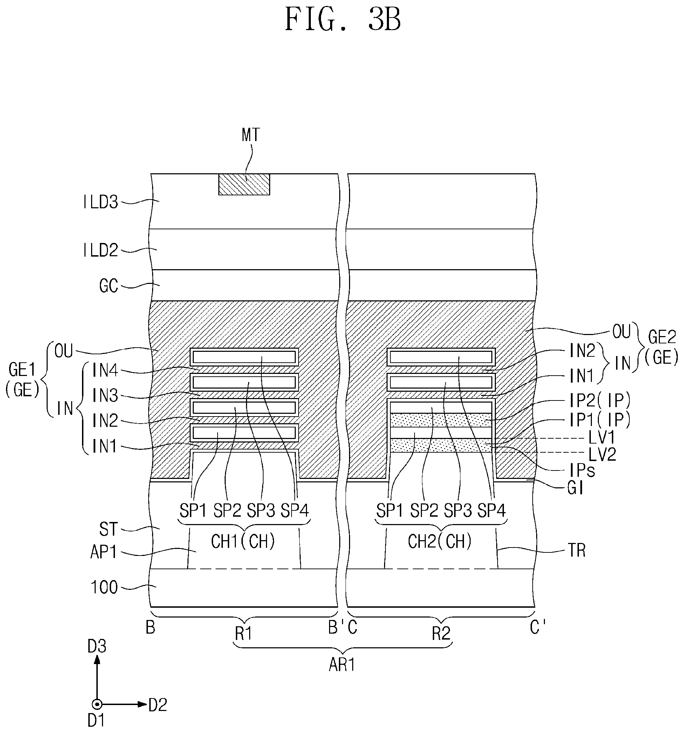

FIG. 3A is a sectional view corresponding to the line A-A' of FIG. 1. FIG. 3B is a sectional view corresponding to the lines B-B' and C-C' of FIG. 1.

Referring to FIGS. 1, 3A, and 3B, the insertion pattern IP may include a first insertion pattern IP1 and a second insertion pattern IP2, which are spaced apart from each other in the third direction D3. The first insertion pattern IP1 may be provided to have substantially the same or similar features as the insertion pattern IP described with reference to FIGS. 1, 2A, and 2B.

The second insertion pattern IP2 may be interposed between the first and second semiconductor patterns SP1 and SP2 of the second channel pattern CH2. Thus, the inner electrode IN of the second gate pattern GE2 may not be provided between the first and second semiconductor patterns SP1 and SP2 of the second channel pattern CH2. Thus, the layer number of the first region R1 may be four, and the layer number of the second region R2 may be two.

In an implementation, a plurality of second insertion patterns IP2 may be provided. The second insertion patterns IP2 may be interposed between the first and second patterns T1 and T2 of the first source/drain pattern SD1 and between the second patterns T2. The second insertion patterns IP2 may be spaced apart from each other in the first direction D1. The second insertion patterns IP2 may be adj acent to the second inner electrode IN2 of the first gate pattern GE1 in the first direction D1.

A bottom surface of the second insertion pattern IP2 may be located at a vertical level higher than the bottom surface T2b of the second pattern T2 of the first source/drain pattern SD1. Each of the second gate pattern GE2 and the gate insulating pattern may cover a side surface of the second insertion pattern IP2.

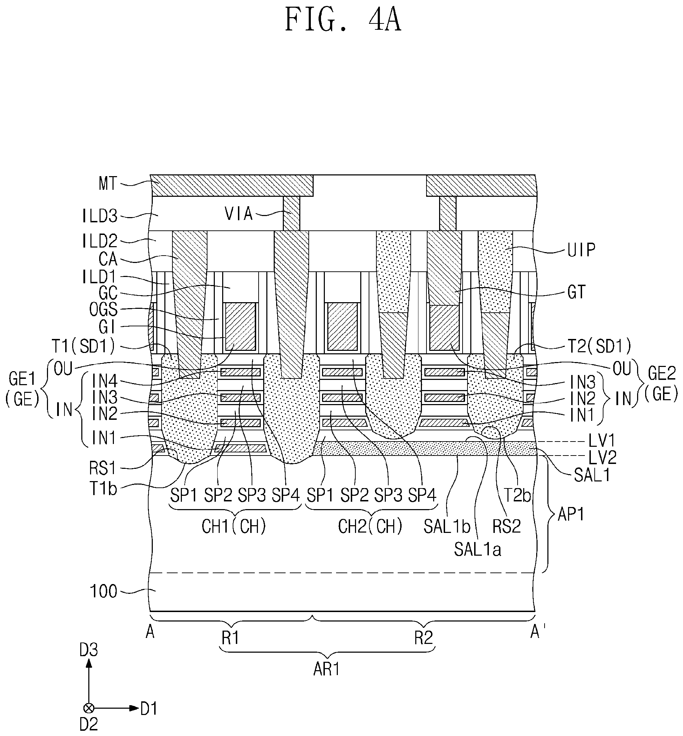

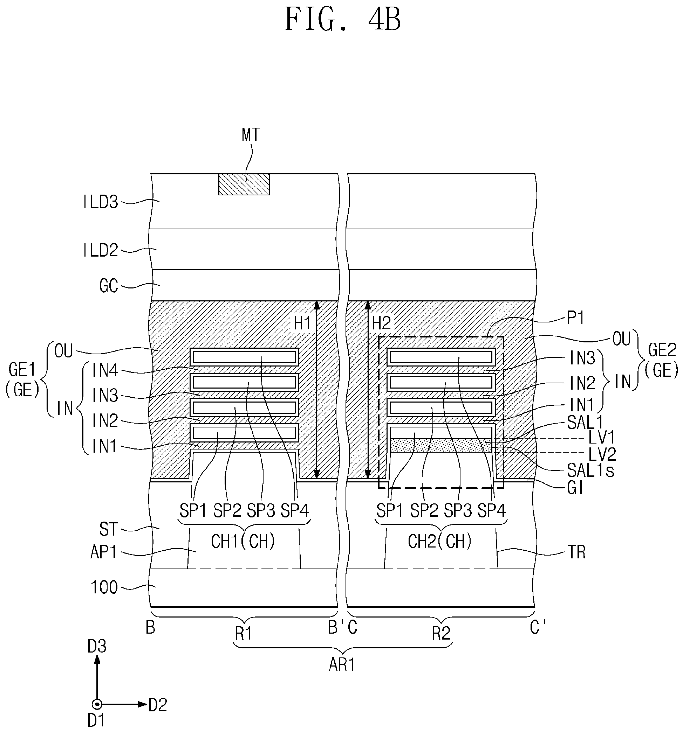

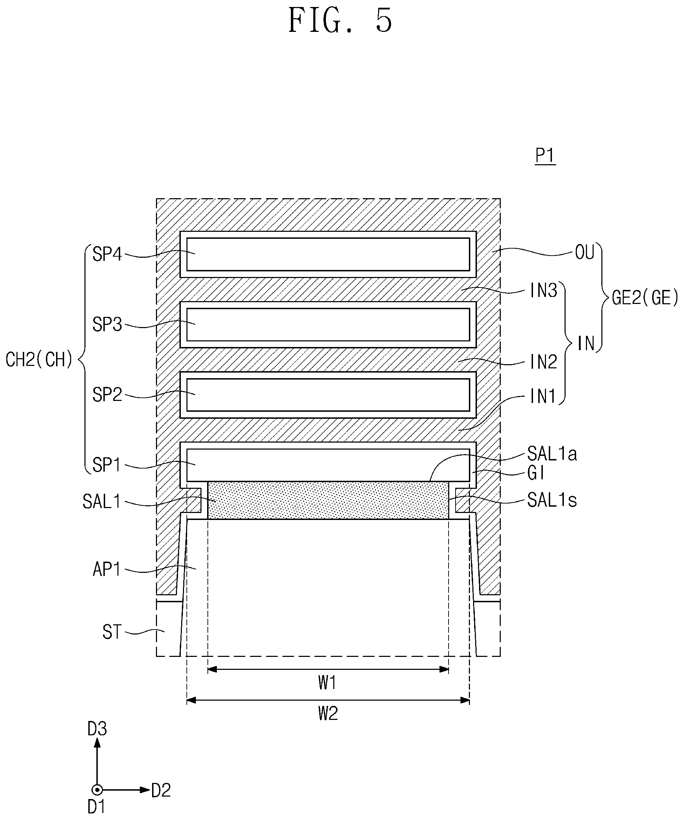

FIG. 4A is a sectional view corresponding to the line A-A' of FIG. 1. FIG. 4B is a sectional view corresponding to the lines B-B' and C-C' of FIG. 1. FIG. 5 is an enlarged sectional view corresponding to a portion P1 of FIG. 4B.

Referring to FIGS. 1, 4A, and 4B, a first sacrificial layer SAL1 may be provided in a region, in which the insertion pattern IP described with reference to FIGS. 1, 2A, and 2B is placed. The first sacrificial layer SAL1 may include SiGe. The germanium concentration of the first sacrificial layer SAL1 may be equal to higher than 15 at% and may be lower than 35 at%.

Referring to FIG. 5, a top surface SAL1a of the first sacrificial layer SAL1 may have a first width W1 in the second direction D2. A bottom surface of the first semiconductor pattern SP1 of the second channel pattern CH2 may have a second width W2. The second width W2 may be larger than the first width W1. Opposite side surfaces of the first semiconductor pattern SP1 of the second channel pattern CH2 may be provided to have a protruding shape in the second direction D2 or the opposite direction of the second direction D2, compared with opposite side surfaces SAL1s of the first sacrificial layer SAL1. A portion of the second gate pattern GE2 may be inserted into a region between the first active pattern AP1 and the first semiconductor pattern SP1 of the second channel pattern CH2.

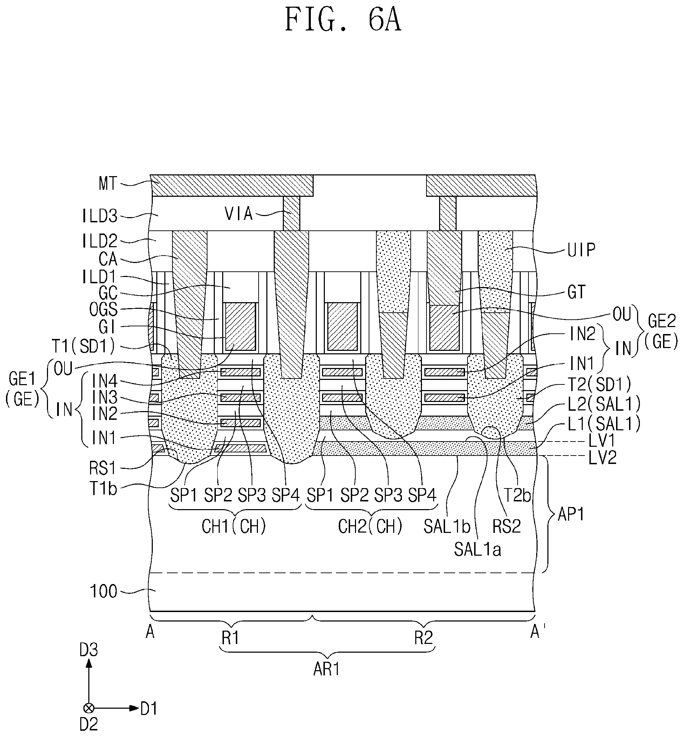

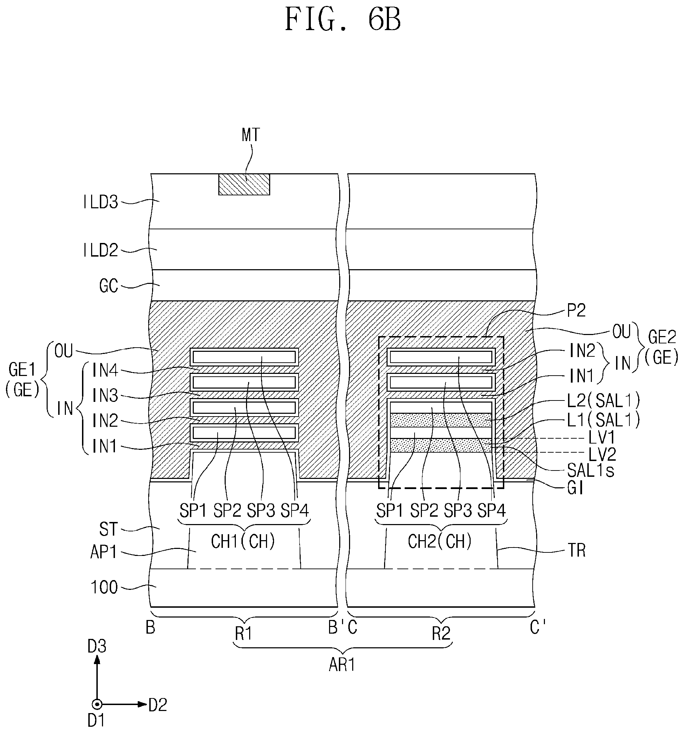

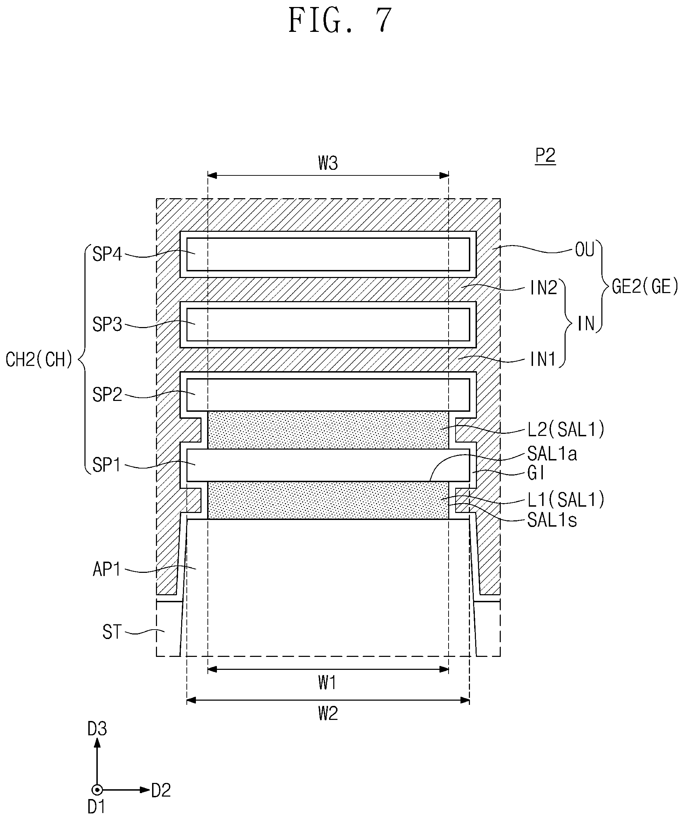

FIG. 6A is a sectional view corresponding to the line A-A' of FIG. 1. FIG. 6B is a sectional view corresponding to the lines B-B' and C-C' of FIG. 1. FIG. 7 is an enlarged sectional view corresponding to a portion P2 of FIG. 6B.

Referring to FIGS. 1, 6A, and 6B, a semiconductor device according to an implementation of the techniques discussed herein may be similar to the semiconductor device described with reference to FIGS. 1, 3A, and 3B. A first pattern L1 of the first sacrificial layer SAL1 may be provided in a region where the first insertion pattern IP1 described with reference to FIGS. 1, 3A, and 3B is placed, and a second pattern L2 of the first sacrificial layer SAL1 may be provided in a region where the second insertion pattern IP2 is placed. Each of the first and second patterns L1 and L2 of the first sacrificial layer SAL1 may be formed of or include SiGe. The germanium concentration of each of the first and second patterns L1 and L2 of the first sacrificial layer SAL1 may be equal to or higher than 15 at% and may be lower than 35 at%.

The relationship between the first pattern L1 of the first sacrificial layer SAL1 and its neighboring elements may be the same as or similar to the relationship between the first sacrificial layer SAL1 described with reference to FIG. 5 and its neighboring elements.

When measured in the second direction D2, a top surface of the second pattern L2 of the first sacrificial layer SAL1 may have a third width W3. The third width W3 may be smaller than the second width W2. The third width W3 may be smaller than a width of each of the semiconductor patterns SP1, SP2, SP3, and SP4 of the second channel pattern CH2 in the second direction D2. Opposite side surfaces of the first semiconductor pattern SP1 of the second channel pattern CH2 may be provided to have a protruding shape in the second direction D2 or the opposite direction of the second direction D2, compared with opposite side surfaces of the second pattern L2 of the first sacrificial layer SAL1. A portion of the second gate pattern GE2 may be inserted into a region between the first and second semiconductor patterns SP1 and SP2 of the second channel pattern CH2.

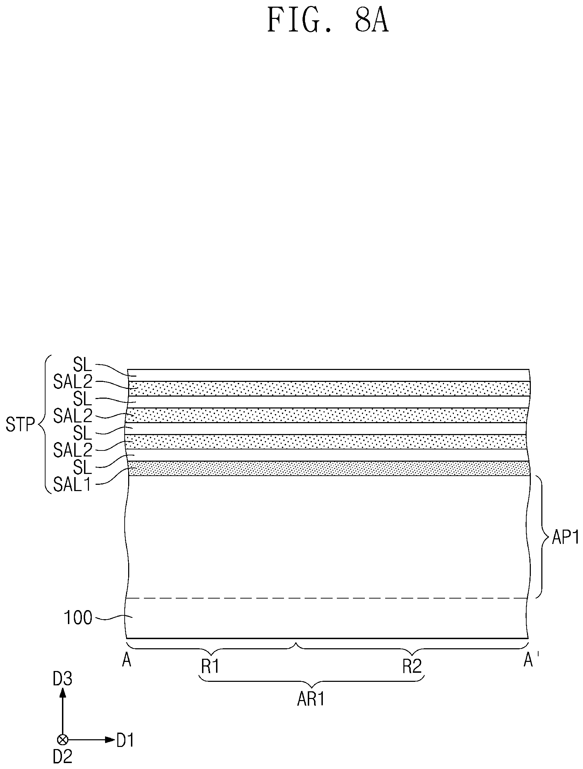

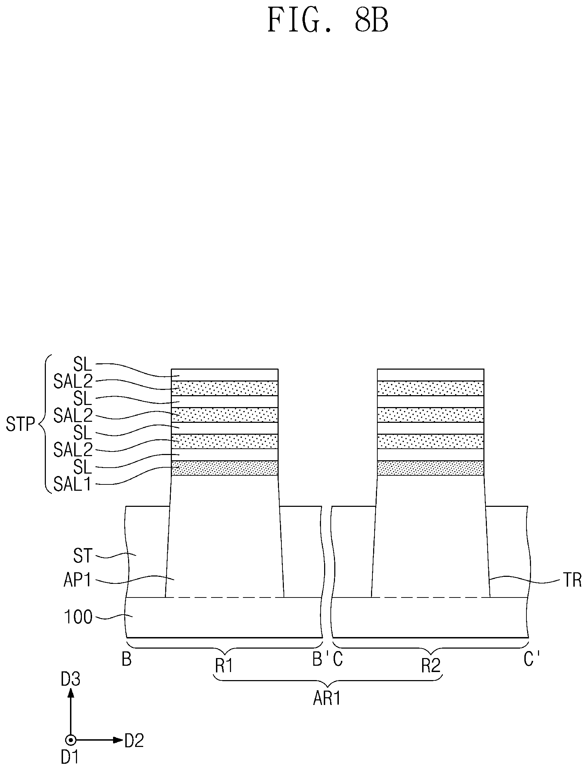

FIGS. 8A to 12B are diagrams illustrating a method of fabricating a semiconductor device according to an implementation of the techniques discussed herein. In detail, FIGS. 8A, 9A, 10A, 11A, and 12A are sectional views corresponding to the lines A-A' of FIG. 1. FIGS. 8B, 9B, 10B, 11B, and 12B are sectional views corresponding to the lines B-B' and C-C' of FIG. 1.

Referring to FIGS. 1, 8A, and 8B, the substrate 100 including the first and second active regions AR1 and AR2 may be provided. Stacking patterns STP may be formed on the first and second active regions AR1 and AR2. In an implementation, the formation of the stacking patterns STP may include forming the first sacrificial layer SAL1 on the substrate 100, alternately stacking semiconductor layers SL and second sacrificial layers SAL2 on the first sacrificial layer SAL1, forming mask patterns extending in the first direction D1, and performing a patterning process using the mask patterns as an etch mask. When the patterning process is performed, a portion of the substrate 100 may also be removed to form the trenches TR. The device isolation patterns ST may be formed to fill the trenches TR.

The first and second sacrificial layers SAL1 and SAL2 may be formed of or include a material capable of having an etch selectivity with respect to the semiconductor layers SL. Thus, the semiconductor layers SL may be scarcely or minimally removed, when the first and second sacrificial layers SAL1 and SAL2 are removed in a subsequent process. In an implementation, the semiconductor layers SL and the first and second sacrificial layers SAL1 and SAL2 may be formed of or include at least one of silicon (Si), germanium (Ge), or silicon-germanium (SiGe), and the material of the semiconductor layers SL may be different from that of the first and second sacrificial layers SAL1 and SAL2.

In an implementation, the first and second sacrificial layers SAL1 and SAL2 may be formed of or include SiGe. The germanium concentration of the first sacrificial layer SAL1 may be higher than the germanium concentration of each of the second sacrificial layers SAL2. The germanium concentration of the first sacrificial layer SAL1 may range from 35 at% to 55 at%. The germanium concentration of each of the second sacrificial layers SAL2 may be equal to or higher than 15 at% and may be lower than 35 at%. Due to the difference in the germanium concentration between the first sacrificial layer SAL1 and the second sacrificial layers SAL2, the second sacrificial layers SAL2 may be scarcely or minimally removed in a subsequent process of removing the first sacrificial layer SAL1.

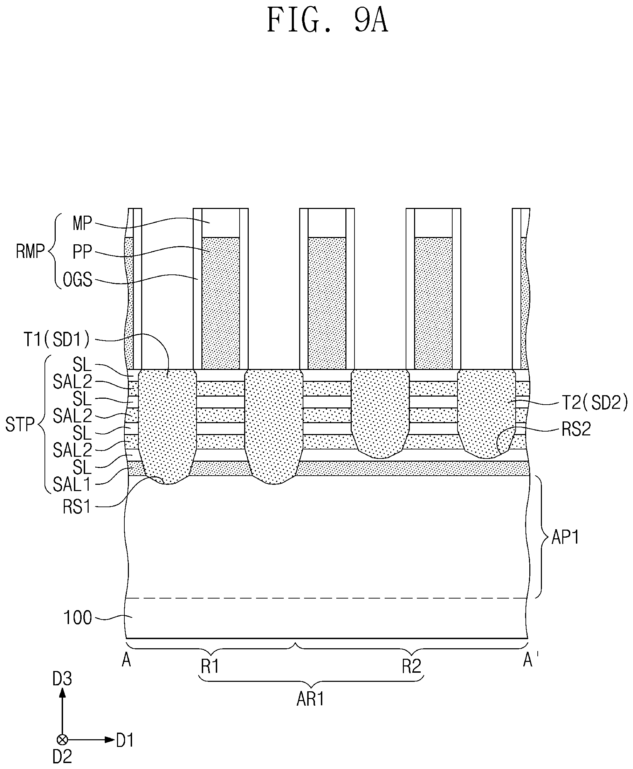

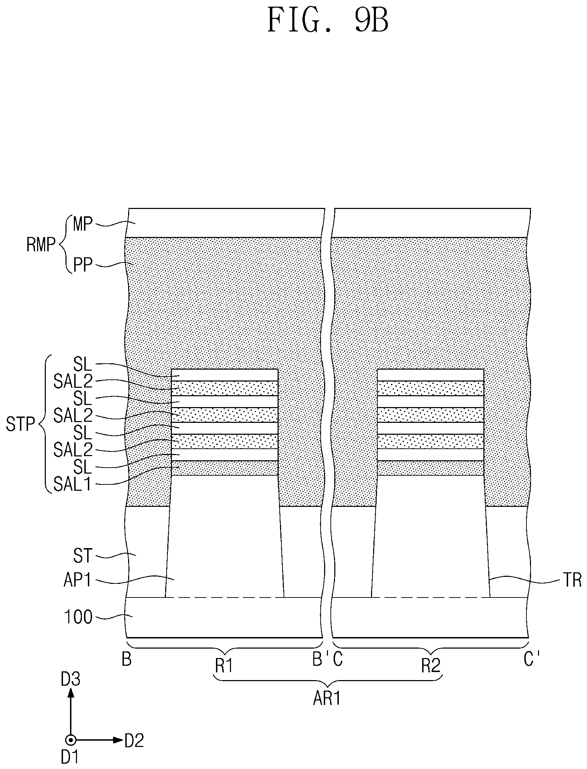

Referring to FIGS. 1, 9A, and 9B, sacrificial patterns PP may be formed on the substrate 100 to extend in the second direction D2. The sacrificial patterns PP may be formed to cover the top surfaces of the device isolation patterns ST and the side and top surfaces of the stacking patterns STP. In an implementation, the formation of the sacrificial patterns PP may include forming a sacrificial layer on the substrate 100, forming hard mask patterns MP on the sacrificial layer, and forming the sacrificial patterns PP by removing a portion of the sacrificial layer using the hard mask patterns MP as an etch mask. In an implementation, the sacrificial pattern PP may be formed of or include polysilicon. The gate spacers OGS may be formed on side surfaces of the sacrificial patterns PP and side surfaces of the hard mask patterns MP. The sacrificial pattern PP, the hard mask pattern MP, and a pair of gate spacers OGS may constitute a recess mask pattern RMP.

The first recesses RS1 may be formed by removing a portion of the stacking pattern STP using a first recess mask pattern RMP1 as a mask. The second recesses RS2 may be formed by removing another portion of the stacking pattern STP using the first recess mask pattern RMP1 as a mask. The processes of forming the first recesses RS1 and the second recesses RS2 may be performed at different times. The first recesses RS1 may be formed to penetrate the first and second sacrificial layers SAL1 and SAL2. In an implementation, the second recesses RS2 may be formed to penetrate the second sacrificial layers SAL2, but not the first sacrificial layer SAL1.

The first source/drain pattern SD1 may be formed to fill the first recesses RS1 and the second recesses RS2 on the first active region AR1. The second source/drain pattern SD2 may be formed to fill first recesses and second recesses on the second active region AR2.

During the process of forming the first source/drain pattern SD1, n-type impurities (e.g., phosphorus, arsenic, or antimony) may be injected into the first source/drain pattern SD1 in an in-situ manner. As another example, the impurities may be injected into the first source/drain pattern SD1, after the formation of the first source/drain pattern SD1.

During the process of forming the second source/drain pattern SD2, p-type impurities (e.g., boron, gallium, or indium) may be injected into the second source/drain pattern SD2 in an in-situ manner. As another example, the impurities may be injected into the second source/drain pattern SD2, after the formation of the second source/drain pattern SD2.

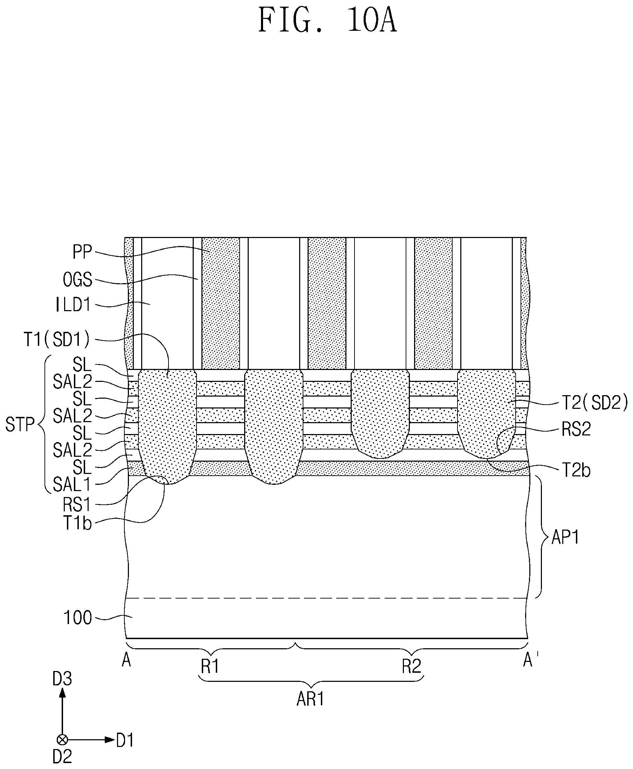

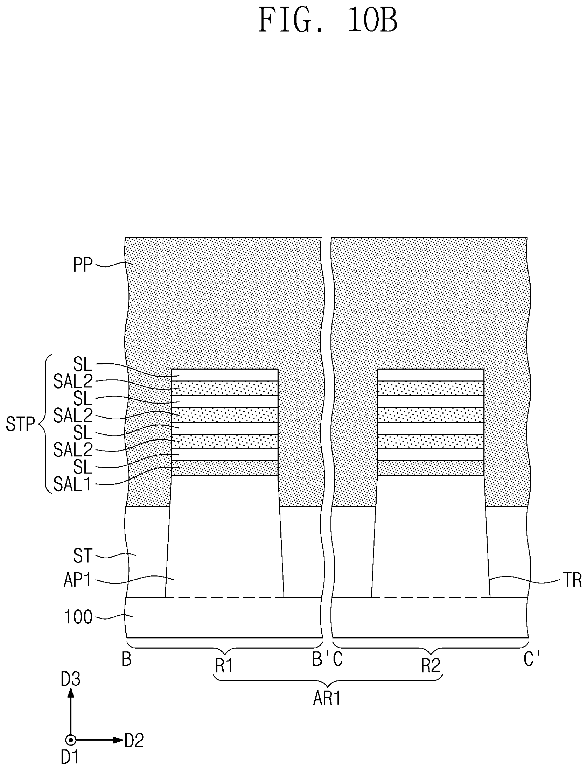

Referring to FIGS. 1, 10A, and 10B, the first interlayer insulating layer ILD1 may be formed to fill a space between the recess mask patterns RMP. Thereafter, an upper portion of the first interlayer insulating layer ILD1 and the hard mask patterns MP may be removed through the planarization process.

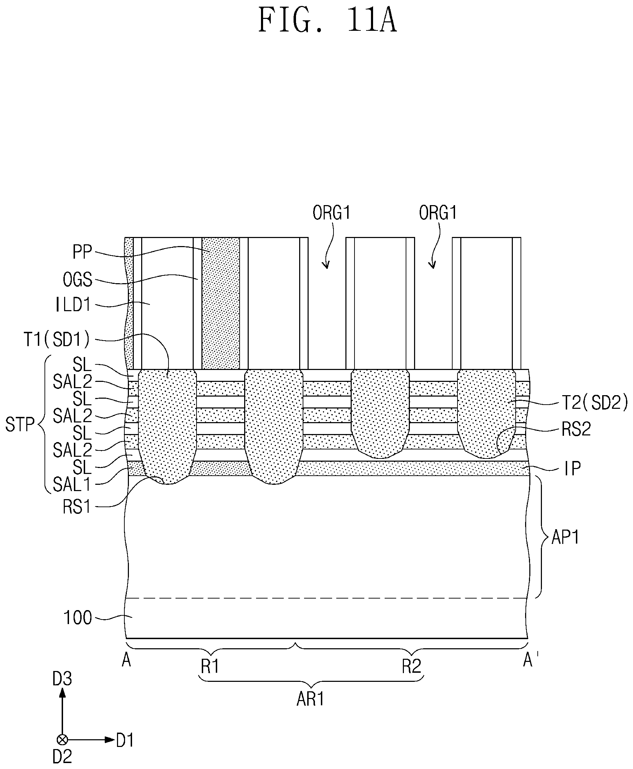

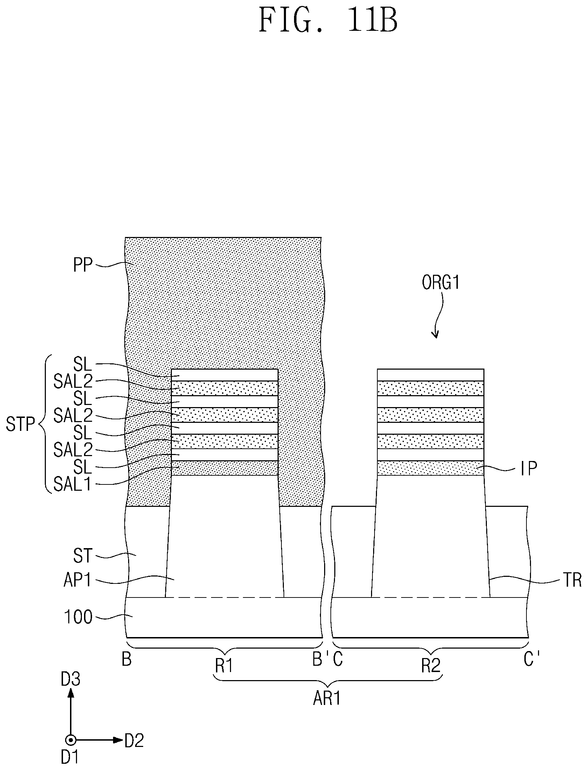

Referring to FIGS. 1, 11A, and 11B, the sacrificial patterns PP on the second region R2 may be removed. Thus, a first outer region ORG1 may be defined between the gate spacers OGS on the second region R2.

The first and second sacrificial layers SAL1 and SAL2 on the second region R2 may be exposed to the outside by the first outer region ORG1. The first sacrificial layer SAL1 on the second region R2 exposed by the first outer region ORG1 may be selectively removed. Here, the semiconductor layers SL on the second region R2 may be scarcely or minimally removed, due to the high etch selectivity compared to the first sacrificial layer SAL1. In addition, the second sacrificial layers SAL2 on the second region R2 may be scarcely or minimally removed, due to the germanium concentration different from the first sacrificial layer SAL1. Thereafter, the insertion pattern IP may be formed in a region, from which the first sacrificial layer SAL1 is removed.

The first and second sacrificial layers SAL1 and SAL2 on the first region R1 may be covered with the sacrificial pattern PP and thus may not be removed when the removal process is performed.

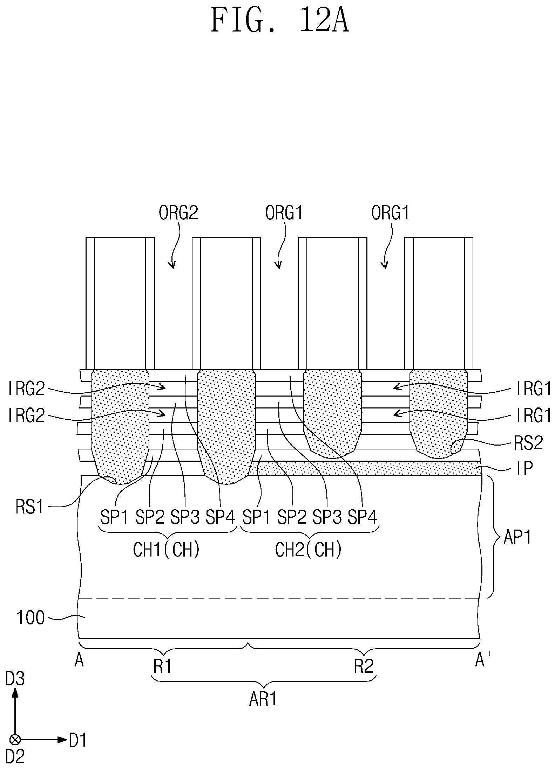

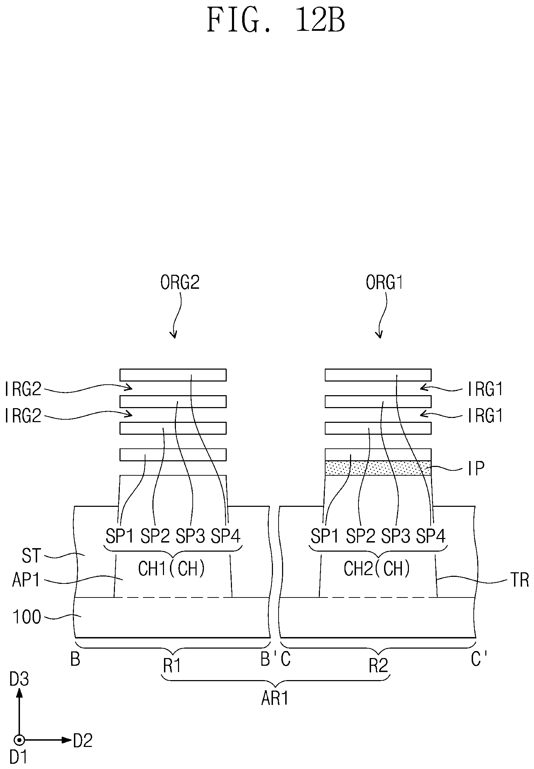

Referring to FIGS. 1, 12A, and 12B, the sacrificial patterns PP on the first region R1 may be removed. Thus, a second outer region ORG2 may be defined between the gate spacers OGS on the first region R1.

The first and second sacrificial layers SAL1 and SAL2 on the first region R1 may be exposed to the outside by the second outer region ORG2. The second sacrificial layers SAL2 on the second region R2 exposed by the first outer region ORG1 and the first and second sacrificial layers SAL1 and SAL2 on the first region R1 exposed by the second outer region ORG2 may be selectively removed. Here, the semiconductor layers SL on the first region R1 may be scarcely or minimally removed, due to the high etch selectivity compared to the first and second sacrificial layers SAL1 and SAL2.

First inner regions IRG1 may be defined in a region, from which the second sacrificial layers SAL2 on the second region R2 are removed. Second inner regions IRG2 may be defined in a region, from which the first and second sacrificial layers SAL1 and SAL2 on the first region R1 are removed.

Referring back to FIGS. 1, 2A, and 2B, the gate insulating pattern GI may be formed in the first and second inner regions IRG1 and IRG2 of FIG. 12A and the first and second outer regions ORG1 and ORG2 of FIG. 12A. The gate insulating pattern GI may be formed to enclose each of the first to fourth semiconductor patterns SP1, SP2, SP3, and SP4.

The gate pattern GE may be formed on the gate insulating pattern GI. The gate pattern GE may include the inner electrodes IN, which are respectively formed in the first and second inner regions IRG1 and IRG2 of FIG. 12A, and the outer electrodes OU, which are formed in the first and second outer regions ORG1 and ORG2 of FIG. 12A. Next, the gate capping pattern GC may be formed on the outer electrode OU of the gate pattern GE.

The second interlayer insulating layer ILD2 may be formed on the first interlayer insulating layer ILD1 and the gate capping pattern GC.

The active contacts CA may be formed to penetrate the first interlayer insulating layer ILD1 and the second interlayer insulating layer ILD2 and may be connected to the first and second source/drain patterns SD1 and SD2. The upper insulating layer UIP may be provided on at least one of the active contacts CA.

The gate contacts GT may be formed to penetrate the second interlayer insulating layer ILD2 and the gate capping pattern GC and may be connected to the gate electrodes GE.

The third interlayer insulating layer ILD3 may be formed on the second interlayer insulating layer ILD2. The metal patterns MT and the via patterns VIA may be formed in the third interlayer insulating layer ILD3.

According to an implementation of the techniques discussed herein, the stacking pattern STP, which includes the first sacrificial layer SAL1 with a high germanium concentration and the second sacrificial layers SAL2 with a low germanium concentration, may be formed on the substrate 100. Thereafter, since the first sacrificial layer SAL1 on the second region R2 is replaced with the insertion pattern IP, the layer number of the first region R1 may be different from the layer number of the second region R2. Apart from the additional presence of the insertion pattern IP, the elements on the first region R1 may be substantially the same or similar to those on the second region R2. Thus, although there is the difference in the layer number between the first and second regions R1 and R2, a process of forming the first gate pattern GE1 on the first region R1 and a process of forming the second gate pattern GE2 on the second region R2 may be performed simultaneously. In addition, a process of forming the recess mask patterns RMP on each of the first and second regions R1 and R2, a process of forming the first source/drain patterns SD1 on each of the first and second regions R1 and R2, and a process of forming the second source/drain patterns SD2 on each of the first and second regions R1 and R2 may be performed simultaneously. In sum, regardless of the difference in the number of layers between the first region R1 and the second region R2, each of the processes on the first and second regions R1 and R2 may be performed simultaneously rather than separately. Thus, it may be possible to simplify a process of fabricating a semiconductor device and to improve the productivity of the semiconductor device.

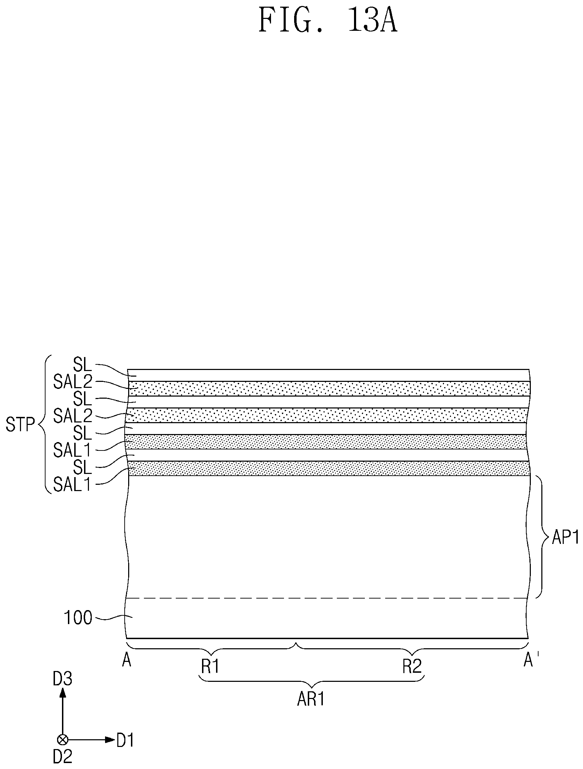

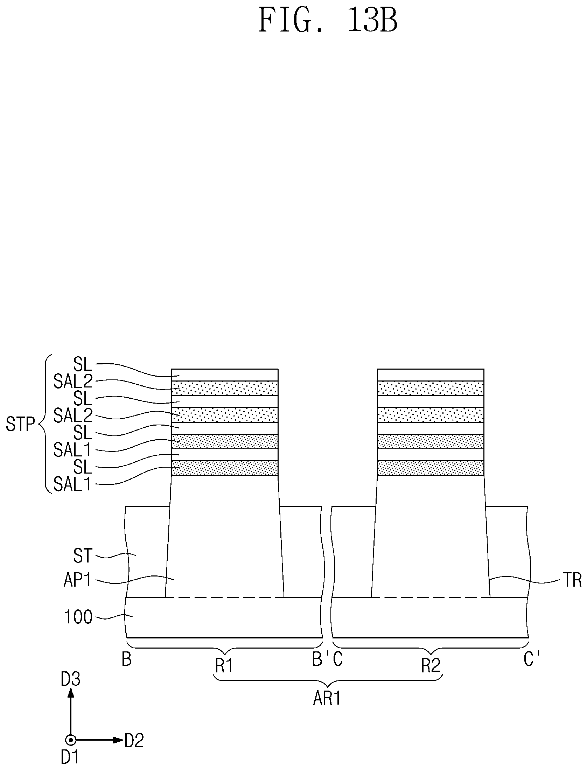

FIGS. 13A and 13B are diagrams illustrating a method of fabricating a semiconductor device according to an implementation of the techniques discussed herein. In detail, FIG. 13A is a sectional view corresponding to the line A-A' of FIG. 1. FIG. 13B is a sectional view corresponding to the lines B-B' and C-C' of FIG. 1.

Referring to FIGS. 1, 13A, and 13B, unlike the process of forming the stacking patterns STP described with reference to FIGS. 1, 8A, and 8B, the formation of the stacking patterns STP may include forming a first stacking pattern, in which the first sacrificial layers SAL1 and the semiconductor layers SL are alternately stacked, on the substrate 100, alternately stacking the second sacrificial layers SAL2 and the semiconductor layers SL on the first stacking pattern, forming mask patterns extended in the first direction D1, and performing a patterning process using the mask patterns as an etch mask. That is, the second sacrificial layer SAL2, which is in contact with the top surface of the lowermost one of the semiconductor layers SL described with reference to FIGS. 1, 8A, and 8B, may be replaced with the first sacrificial layer SAL1.

Thereafter, the fabrication method described above may be applied to fabricate the semiconductor device described with reference to FIGS. 1, 3A, and 3B.

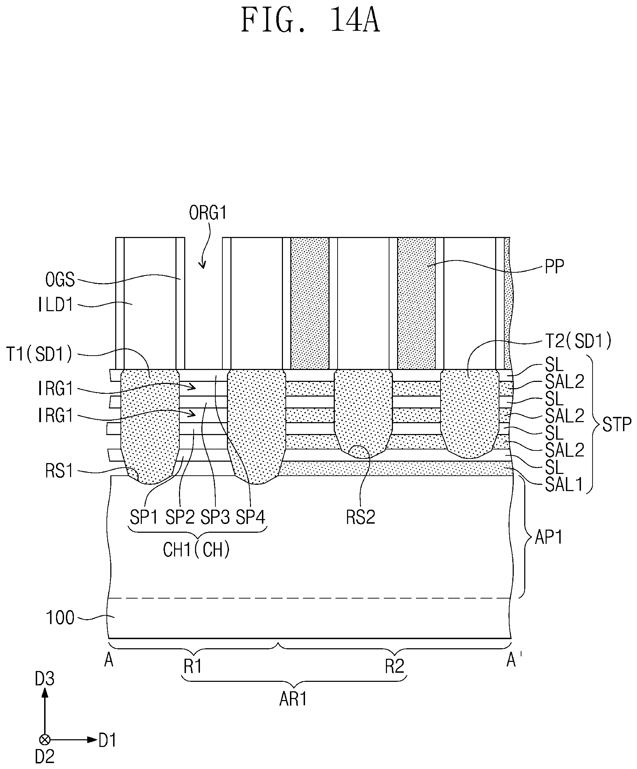

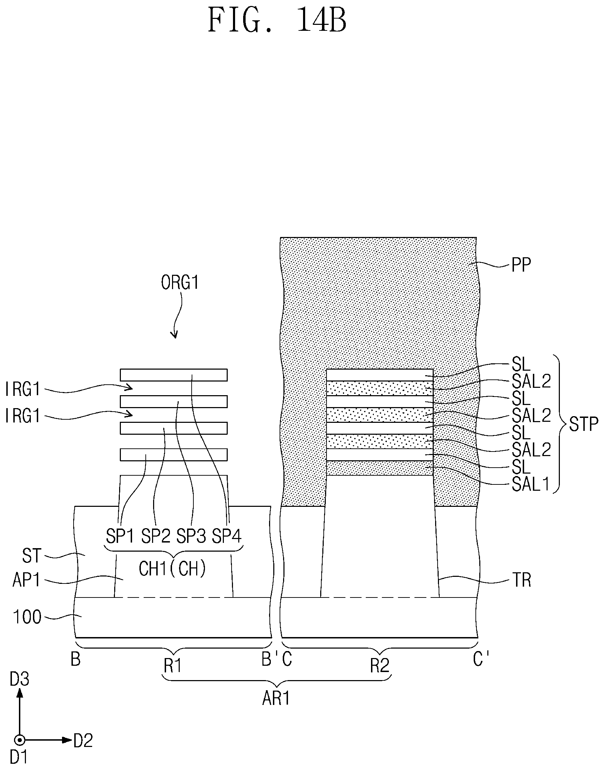

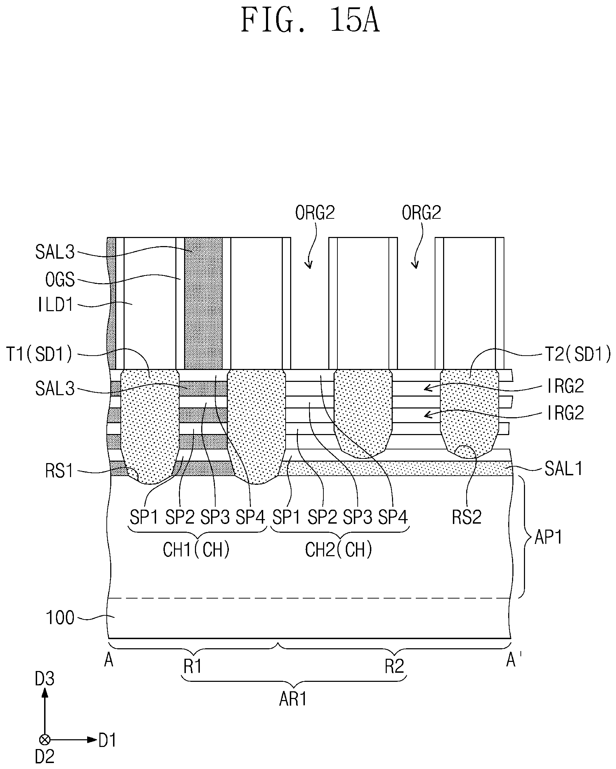

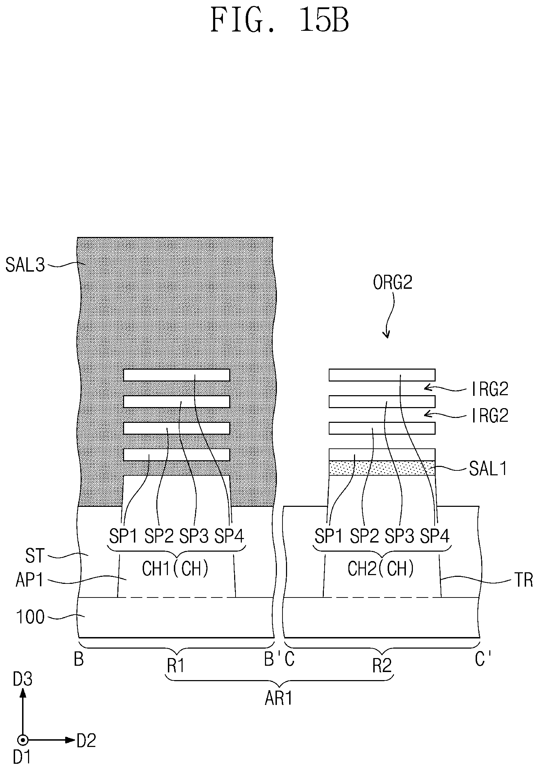

FIGS. 14A to 15B are diagrams illustrating a method of fabricating a semiconductor device according to an implementation of the techniques discussed herein. In detail, FIGS. 14A and 15A are sectional views corresponding to the line A-A' of FIG. 1. FIGS. 14B and 15B are sectional views corresponding to the line B-B' and C-C' of FIG. 1.

Referring to FIGS. 1, 14A, and 14B, unlike that described with reference to FIGS. 1, 8A, and 8B, the germanium concentration of the first sacrificial layer SAL1 may be lower than the germanium concentration of each of the second sacrificial layers SAL2. In an implementation, the germanium concentration of each of the second sacrificial layers SAL2 may range from 35 at% to 55 at%. As an example, the germanium concentration of the first sacrificial layer SAL1 may be equal to or higher than 15 at% and may be lower than 35 at%. Due to a difference in the germanium concentration between the first and second sacrificial layers SAL1 and SAL2, the first sacrificial layer SAL1 may be less removed, when the second sacrificial layers SAL2 are removed in a subsequent removal process.

After the planarization process described with reference to FIGS. 1, 10A, and 10B, the sacrificial pattern PP on the first region R1 may be removed. Thus, the first outer region ORG1 may be defined between the gate spacers OGS on the first region R1. The first and second sacrificial layers SAL1 and SAL2 may be selectively removed from the first region R1 that is exposed through the first outer region ORG1. Thus, the first inner regions IRG1 may be formed on the first region R1. In addition, the first channel pattern CH1 may be formed on the first region R1.

The first and second sacrificial layers SAL1 and SAL2 on the second region R2 may be covered with the sacrificial pattern PP and may not be removed when the removal process is performed.

Referring to FIGS. 1, 15A, and 15B, a third sacrificial layer SAL3 may be formed to fill the first outer region ORG1 of FIG. 14A and the first inner regions IRG1 of FIG. 14A. The third sacrificial layer SAL3 may be formed to enclose and cover the first channel pattern CH1.

Thereafter, the sacrificial pattern PP of FIG. 14A on the second region R2 may be removed. Thus, the second outer region ORG2 may be defined between the gate spacers OGS on the second region R2. The second sacrificial layers SAL2 may be selectively removed from the second region R2 exposed through the second outer region ORG2. Thus, the second inner regions IRG2 may be formed on the second region R2. In addition, the second channel pattern CH2 may be formed on the second region R2.

Due to its germanium concentration being different from that of the second sacrificial layers SAL2, the first sacrificial layer SAL1 on the second region R2 may be minimally removed and remain on the second region R2, unlike that described with reference to FIGS. 1, 12A, and 12B. In an implementation, opposite side surfaces of the first sacrificial layer SAL1 may be recessed laterally, and thus, each of the first to fourth semiconductor patterns SP1, SP2, SP3, and SP4 of the second channel pattern CH2 may be formed to have protruding side surfaces compared to the side surfaces of the first sacrificial layer SAL1, as described with reference to FIGS. 5 and 7.

Thereafter, the fabrication method described above may be applied to fabricate the semiconductor device described with reference to FIGS. 1, 4A, 4B, and 5 or the semiconductor device described with reference to FIGS. 1, 6A, 6B, and 7.

According to an implementation of the techniques discussed herein, an insertion pattern including an insulating material may be formed on a portion of an active region, and here, the insertion pattern may be interposed between a substrate and the lowermost one of semiconductor patterns constituting a channel pattern. Thus, an inner electrode of a gate pattern on the portion of the active region may not be provided between the lowermost semiconductor pattern and the substrate. As a result, an overlapping region between the gate pattern and the channel pattern may be reduced. The insertion pattern may not be provided on other portion of the active region, and thus, on the other portion of the active region, an overlapping region between the gate pattern and the channel pattern may be increased. Since devices with different numbers of layers are provided on each active region, it may be possible to simultaneously provide a device with improved electrical characteristics and a device with improved power consumption characteristics, on each active region. Thus, it may be possible to improve a degree of freedom in designing a semiconductor device.

According to an implementation of the techniques discussed herein, since the insertion pattern is provided at the afore-mentioned position, it may be possible to reduce a parasitic capacitance between a source/drain pattern and the gate pattern. In addition, the insertion pattern includes a nitride-containing insulating material, it may be possible to more effectively reduce the parasitic capacitance. As a result, the electric characteristics of the semiconductor device may be improved.

According to an implementation of the techniques discussed herein, a stacking pattern, which includes a first sacrificial layer with a high germanium concentration and a second sacrificial layers with a low germanium concentration, may be formed on the substrate. Thereafter, the first sacrificial layer on a portion of the active region may be replaced with the insertion pattern, and thus, the layer number on the portion of the active region may be different from that on another portion of the active region. Apart from the additional presence of the insertion pattern, the elements on the portion of the active region may be substantially the same or similar to those on another portion of the active region. Thus, regardless of the difference in the number of layers, some of the semiconductor fabrication processes may be performed simultaneously, rather than separately, on the two different portions of the active region. As a result, it may be possible to simplify a process of fabricating a semiconductor device and to increase the productivity of the semiconductor device.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While example implementations of the techniques discussed herein have been particularly shown and described, it will be understood by one of ordinary skill in the art that variations in form and detail may be made therein without departing from the spirit and scope of the attached claims.

## Claims

1. A semiconductor device comprising:
a first active region on a substrate;
a first channel pattern and a second channel pattern on the first active region, each of the first channel pattern and the second channel pattern comprising a plurality of semiconductor patterns, wherein the plurality of semiconductor patterns are vertically stacked with respect to the substrate and are spaced apart from each other;
a first gate pattern crossing the first channel pattern;
a second gate pattern crossing the second channel pattern; and
an insertion pattern between the substrate and a lowermost semiconductor pattern of the plurality of semiconductor patterns of the second channel pattern,
wherein a number of inner electrodes of the first gate pattern is greater than a number of inner electrodes of the second gate pattern, and
wherein the second gate pattern covers a side surface of the insertion pattern.

2. The semiconductor device of claim 1, wherein a bottom surface of the first gate pattern is located at a vertical level that is a same as a vertical level of a bottom surface of the second gate pattern.

3. The semiconductor device of claim 1, wherein a height of the first gate pattern is a same as a height of the second gate pattern.

4. The semiconductor device of claim 1, wherein a bottom surface of the second gate pattern is located at a vertical level that is lower than a vertical level of a top surface of the insertion pattern.

5. The semiconductor device of claim 1, comprising a gate insulating pattern enclosing the semiconductor patterns of the second channel pattern,
wherein the gate insulating pattern is interposed between the second gate pattern and the insertion pattern.

6. The semiconductor device of claim 1, wherein the insertion pattern comprises a composite material comprising Si and N.

7. The semiconductor device of claim 1, wherein
the inner electrodes of the first gate pattern are interposed between the plurality of semiconductor patterns of the first channel pattern and between the substrate and a lowermost semiconductor pattern of the plurality of semiconductor patterns of the first channel pattern, and
the inner electrodes of the second gate pattern are interposed between the plurality of semiconductor patterns of the second channel pattern.

8. The semiconductor device of claim 1, comprising a plurality of second channel patterns comprising the second channel pattern wherein,
the semiconductor device comprises a source/drain pattern between the plurality of second channel patterns, and
a bottom surface of the source/drain pattern is located at a vertical level that is a same as or greater than a vertical level of a top surface of the insertion pattern.

9. The semiconductor device of claim 1, comprising a plurality of second channel patterns comprising the second channel pattern wherein,
the semiconductor device comprises a source/drain pattern between the plurality of second channel patterns, and
the insertion pattern extends in a first direction below the source/drain pattern, the first direction being parallel to a top surface of the substrate.

10. The semiconductor device of claim 1, comprising a plurality of first channel patterns comprising the first channel pattern and a plurality of second channel patterns comprising the second channel pattern, wherein,
the semiconductor device comprises a source/drain pattern on the first active region,
the source/drain pattern comprises a first pattern between the plurality of first channel patterns and a second pattern between the plurality of second channel patterns, and
a height of the first pattern of the source/drain pattern is greater than a height of the second pattern of the source/drain pattern.

11. The semiconductor device of claim 10, wherein a bottom surface of the first pattern of the source/drain pattern is at a vertical level that is lower than a vertical level of a bottom surface of the insertion pattern.

12. The semiconductor device of claim 1, comprising a first active pattern on the first active region that extends in a first direction that is parallel to a top surface of the substrate,
wherein each of the first channel pattern and the second channel pattern is on the first active pattern.

13. The semiconductor device of claim 12, wherein a top surface of the first active pattern below the first channel pattern is located at a vertical level that is a same as a vertical level of a top surface of the first active pattern below the second channel pattern.

14. A semiconductor device, comprising:
a first active region on a substrate;
a first channel pattern and a second channel pattern on the first active region, each of the first channel pattern and second channel pattern comprising a plurality of semiconductor patterns wherein the plurality of semiconductor patterns are vertically stacked with respect to the substrate and are spaced apart from each other;
a first gate pattern crossing the first channel pattern;
a second gate pattern crossing the second channel pattern; and
an insertion pattern between the substrate and a lowermost semiconductor pattern of the plurality of semiconductor patterns of the second channel pattern,
wherein a number of inner electrodes of the first gate pattern is greater than a number of inner electrodes of the second gate pattern, and
wherein a bottom surface of the second gate pattern is at a vertical level that is lower, with respect to the substrate, than a vertical level of a top surface of the insertion pattern.

15. The semiconductor device of claim 14, wherein a height of the first gate pattern is a same as a height of the second gate pattern.
